# EUROPEAN PATENT SPECIFICATION

(11) **EP 0 521 677 B1**
(45) Date of publication and mention of the grant of the patent: **06.11.1996**
(21) Application number: 92305956.2
(22) Date of filing: 29.06.1992
(51) Int. Cl.: H03M 9/00

(54) **Parallel to serial data transfer system**
Parallel-Serien Datenwandlungsystem
Système de conversion de données parallèle-série

(30) Priority: 29.06.1991 JP 185224/91
(43) Date of publication of application: 07.01.1993
(73) Proprietor: NEC CORPORATION, Tokyo (JP)
(72) Inventor: Yoshida, Hiroshi, c/o NEC Engineering Ltd., Minato-ku, Tokyo (JP); Nakahara, Kenji, c/o NEC Corporation, Minato-ku, Tokyo (JP)
(74) Representative: Orchard, Oliver John

(56) References cited:
- GB-A- 2 187 578
- US-A- 4 885 584
- PATENT ABSTRACTS OF JAPAN vol. 13, no. 184 (E-751)28 April 1989

## Description

This invention relates to a parallel to serial data transfer system, and more particularly to, a parallel to serial data transfer system for transferring burst serial data from received parallel data.

A conventional parallel to serial data transfer system includes a CPU (central processing unit) for supplying parallel data of one byte at a time, a buffer connected to the CPU for storing the parallel data transferred from the CPU, and a parallel to serial shift register connected to the buffer for converting parallel data to serial data.

In operation, when a write request signal is supplied to the CPU, parallel data of one byte is transferred from the CPU to the buffer. Then, the parallel data is loaded from the buffer to the parallel to serial shift register. After that, the parallel data of one byte loaded in the shift register are read therefrom one bit by one bit in synchronism with a clock signal. Thus, the parallel data are converted to serial data.

With the conventional parallel to serial data transfer system, however, there are disadvantages in that the load of the CPU becomes large, because the CPU has to access the buffer at every transfer of one byte in response to the write request signal, so that the CPU has to access the buffer "m" times in the case of the transfer of "m" bytes of data. Further, if the buffer has a memory capacity of "n" bytes more than "m" bytes of parallel data transferred from the CPU, the "n-m" bytes has to be filled with dummy data, so that the load of the CPU becomes larger.

In the specification of UK patent application number 8605757, which was published under number 2187578 on September 9 1987, there was proposed a parallel to serial converter using a shift register into which a data word was loaded in parallel and shifted out serially. As the data was shifted out, a string of zeros was shifted in and, when a predetermined number of zeros was detected, a flip flop was set at the next clock beat to switch the shift register into its parallel load mode.

In the specification of Japanese patent application number 870165046, which was published under number 1008731 on January 12 1989, and in patent abstracts of Japan Vol. 13, No. 184(E-751) published on April 28 1989, summarizing the specification of the patent application, there was proposed a digital parallel to serial converter in which a ready signal was output from a ready signal output terminal to indicate that the converter was ready to extract serially processed data.

A serializer for converting parallel data into serial data with variable character length possibilities was described in the specification of United States patent number 4,885,584, which was published on December 5 1989.

There will be described below, as an example, a parallel to serial data transfer system in which the load of the CPU is decreased, and the control of the CPU is simplified.

In a particular illustrative arrangement to be described below a parallel to serial data transfer system, includes a data processing unit for the supply of parallel data of "m" bytes in a successive manner, where "m" is an integer to or larger than 1, a buffer for holding the parallel data of "m" bytes, the buffer having a capacity of "n" bytes, where "n" is an integer equal to or larger than 1, and for generating an empty flag, when no parallel data is held therein, a shift register for the supply of serial data of "m" bytes by being loaded with the parallel data of "m" bytes in a successive manner, and for the supply of a constant value, when no parallel data is loaded therein, and a control circuit for prohibiting a load of parallel data to the shift register, when the empty flag is generated.

The following description and drawings disclose a previously proposed arrangement and, by means of an example, the invention which is characterised in the appended claims, whose terms determine the extent of the protection conferred hereby.

In the drawings:-
Fig. 1 is a circuit diagram showing a previously proposed parallel to serial data transfer system,
Fig. 2 is a circuit diagram showing a parallel to serial data transfer system of a preferred embodiment, illustrative of the invention, and
Fig. 3 is a timing chart showing operation of the preferred embodiment.

Before describing a parallel to serial data transfer system illustrative of the invention, the briefly aforementioned previously proposed parallel to serial data transfer system will be explained.

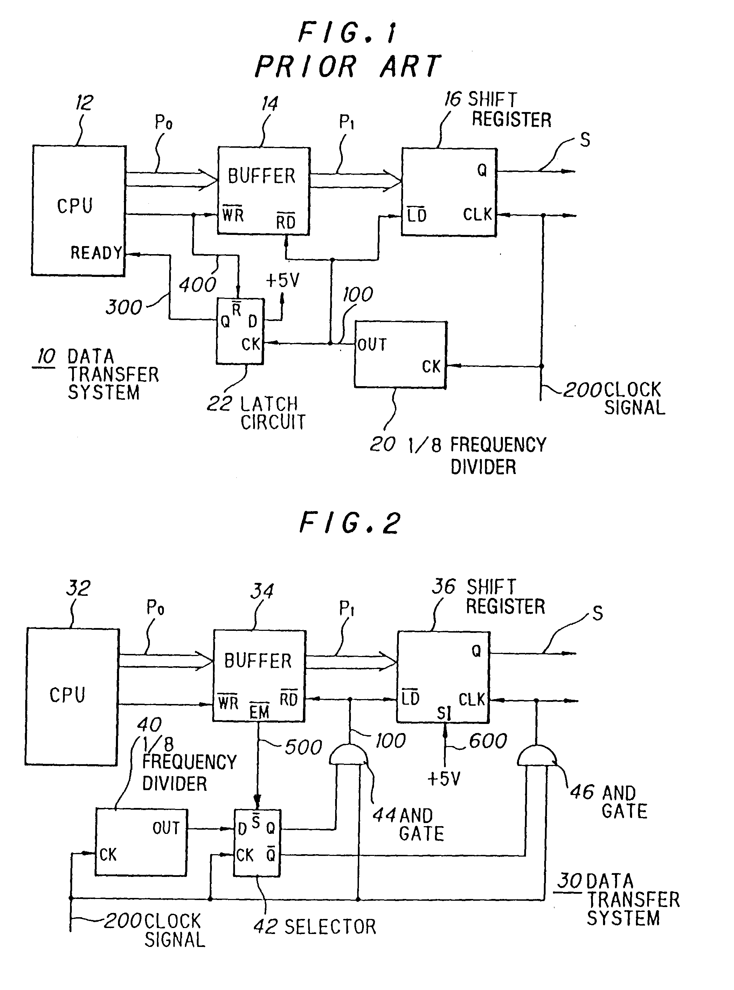

Fig. 1 shows the previously proposed parallel to serial data transfer system 10 which includes a CPU (central processing unit) 12 for supplying parallel data "Po" one byte by one byte, a buffer 14 connected to the CPU 12 for storing the parallel data "Po" and transferring parallel data "P1" one byte by one byte, a parallel to serial shift register 16 connected to the buffer 14 for converting the parallel data "P1" into serial data "S", a 1/8 frequency divider 20 for supplying a load signal 100 to the buffer 14 and the shift register 16 in accordance with a clock signal 200, and a latch circuit 22 connected to the CPU 12 and to the 1/8 frequency divider 20 for supplying a write request signal 300 to the CPU 12 in response to the load signal 100.

In operation, when eight pulses of the clock signal 200 are supplied to the 1/8 frequency divider 20, a load signal 100 is supplied to the latch circuit 22, to the buffer 14 and to the shift register 16. In response to the load signal 100, the latch circuit supplies a write request signal 300 to the CPU 12, so that parallel data "Po" of one byte is transferred to the buffer 14 in accordance with a write signal 400. At this time, a write signal 400 is supplied to a reset terminal of the latch circuit 22, so that the latch circuit 22 is reset.

Then, in response to the load signal 100,parallel data "Pl" is transferred from the buffer 14 to the shift register 16, and the parallel data "P1" of one byte is transferred from the parallel to serial shift register 16 one bit by one bit in synchronism with the clock signal 200, so that the parallel to serial conversion of the transfer data is made.

With the previously proposed parallel to serial data transfer system 10, however, there are disadvantages in that the load of the CPU 12 becomes large, because the CPU 12 has to access the buffer 14 at every time one byte is transferred in response to the write request signal 300. Further, if the buffer 14 has a memory capacity of "n" bytes more than "m" bytes of parallel data transferred from the CPU 12, the buffer 14 has to be controlled in order that data of "n-m" bytes are not accessed, so that the control of the CPU 12 becomes complicated.

Fig. 2 shows a parallel to serial data transfer system 30 of a preferred embodiment illustrative of the invention, which includes a CPU (central processing unit) 32 for supplying parallel data "Po" continuously byte by byte, a buffer 34 connected to the CPU 32 for storing the parallel data "Po" and transferring parallel data "P1" byte by byte, a shift register 36 connected to the buffer 34 for converting the parallel data "P1" into serial data "S", a 1/8 frequency divider 40 for supplying an output signal for eight pulses of a clock signal 200, a selector connected to the buffer 34 and the 1/8 frequency divider 40, an AND gate 44 connected at inputs to a non-inverted output of the selector 42 and to the clock signal 200 and at an output to the buffer 34 and the shift register 36, and an AND gate 46 connected at inputs to an inverted output of the selector 42 and to the clock signal 200 and at an output to the shift register 36.

The buffer 34 supplies an empty flag 500 to the selector 42, when no parallel data is stored therein. The parallel to serial shift register 36 is supplied with a constant serial voltage, so that constant serial data is supplied from the Q output of the shift register 36, when eight pulses of the clock signal 200 are counted when the empty flag is low.

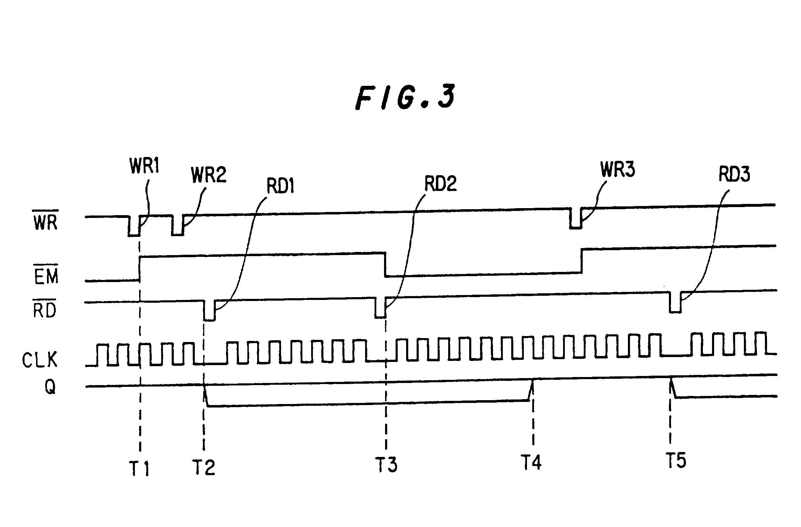

Next, the operation of the preferred embodiment will be explained in conjunction with Fig. 3. When parallel data "Po" of two bytes are transferred from the CPU 32 to the buffer 34 by the write signals WR1 and WR2, the two parallel data "Po" are successively written therein. At the time "T1", an empty flag 500 (EM) becomes high level to be supplied from the buffer 34 to the selector 42. On the other hand, when eight pulses of the clock signal 200 are supplied to the 1/8 frequency divider 40, an output signal is supplied from the 1/8 frequency divider 40 to the selector 42. Thus, the non-inverted output of the selector 42 is supplied to the AND gate 44 and the inverted output is supplied to the AND gate 46, so that a read and load signal 100 is supplied to the buffer 34 and to the shift register 36 at a time T2, as shown by "RD1" in Fig. 3. Then, the first parallel data "Po" stored in the buffer 34 is transferred to the shift register 36 as parallel data "P1".

The parallel data loaded into the shift register 36 is shifted out therefrom bit by bit, so that serial data "S" is supplied from the Q output thereof by eight pulses of the clock signal 200. Then, the read signal RD2, as shown in Fig. 3, is generated together with the load signal in accordance with the output 100 of the AND gate 44 at the time T3, so that the second parallel data "P1" is transferred, from the buffer 34 to the shift register 36. Thus, an eight bit serial data "S" is obtained at the Q output of the shift register 36 in the same manner as the first parallel data. At the time T3, the buffer 3 becomes empty, so that the empty flag EM becomes low. At this state, eight pulses of the clock signal 200 are counted at the time T4, a constant serial data is generated at the Q output of the shift register 36 in accordance with the voltage 600 applied to the S1 terminal, and is finished to be generated at the time T5, when the read signal RD3 is generated subsequently to the write signal WR3. Thus, parallel data written into the buffer 34 by the signal WR3 and loaded into the shift register 36 by the signal RD3 is shifted out from the shift register 36 bit by bit as an eight bit serial data.

As described above, "m" bytes of parallel data can be successively written from a CPU to a buffer having a capacity of "n" bytes (m ≦ n) without access of the CPU to the buffer for each byte, and the supply of serial data from a shift register is controlled by an empty flag generated by the buffer, so that the load of the CPU is - decreased. In addition, the CPU may write "m" bytes of parallel data in a burst manner to the buffer in a predetermined time, during which the "m" bytes of serial data are supplied from the shift register, so that the CPU is not required to have a write request signal to simplify the control of the CPU.

Although the invention has been described, by way of example, with respect to a specific embodiment, it will be understood that it is not to be limited thereto, and that modifications and variations thereof and other embodiments may be made within the scope of the appended claims.

## Claims

1. A parallel to serial data transfer system (30) including a data processing unit (32), a buffer (34) connected to the parallel data output of the data-processing unit (32) to hold parallel data written from the data-processing unit (32), a shift register (36) connected to the output of the buffer (34) to convert the parallel data output from the buffer (34) to serial data, means to supply clock signals to the shift register (36), means to supply serial data from the shift register (36) to a following stage in accordance with clock signals supplied to the shift register (36), and a frequency divider (40) having an input connected to the clock signals to provide an output clock signal derived from the input clock signals divided by a predetermined number, the divided clock signal output from the divider (40) being connected to the buffer (34) and to the shift register (36) to cause the parallel data to be read from the buffer (34) and to be loaded into the shift register (36), characterised in that there are provided means (EM) for generating an empty signal (500) at an output of the buffer (34) when the buffer (34) holds no parallel data, and means (42) for preventing the divided clock signal from being supplied to the buffer and the shift register (36), when the empty signal (500) is generated, the parallel data being written into the buffer (34) regardless of the clock signal from the data processing unit (32), and the serial data being supplied from the shift register (36) to a following stage simultaneously with the transfer of data from the buffer (34) to the shift register (36).

2. A parallel to serial data transfer system (30) as claimed in claim 1, in which the generating means (EM) is an empty terminal of the buffer (34).

3. A parallel to serial data transfer system (30) as claimed in claim 1 in which the shift register (36) is supplied with constant DC voltage (600).

## Patentansprüche

1. Parallel/Seriell-Datenwandlungssystem (30) aufweisend eine Datenverarbeitungseinheit (32), einen mit dem parallelen Datenausgang der Datenverarbeitungseinheit (32) verbundenen Puffer (34) zum Zwischenspeichern von von der Datenverarbeitungseinheit (32) geschriebenen Daten, ein mit dem Ausgang des Puffers (34) verbundenes Schieberegister (36) zum Umwandeln der von dem Puffer (34) ausgegebenen parallelen Daten in serielle Daten, eine Einrichtung zum Liefern von Taktsignalen an das Schieberegister (36), eine Einrichtung zum Liefern serieller Daten aus dem Schieberegister (36) an eine nachfolgende Stufe in Übereinstimmung mit an das Schieberegister (36) gelieferten Taktsignalen, und einen Frequenzteiler (40) mit einem mit den Taktsignalen verbundenen Eingang zum Erzeugen eines von den durch eine vorgegebene Zahl dividierten Eingangstaktsignalen abgeleiteten Ausgangstaktsignals, wobei das dividierte Ausgangstaktsignal aus dem Teiler (40) an den Puffer (34) und das Schieberegister (36) angelegt ist, um das Auslesen der parallelen Daten aus dem Puffer (34) und das Laden in das Schieberegister (36) zu bewirken, dadurch gekennzeichnet, daß eine Einrichtung (EM) zum Erzeugen eines Leer-Signals (500) an einem Ausgang des Puffers (34), wenn der Puffer (34) keine parallelen Daten zwischenspeichert, und eine Einrichtung (42) vorgesehen sind, um zu verhindern, daß das geteilte Taktsignal an den Puffer und das Schieberegister (36) geliefert wird, wenn das Leer-Signal (500) erzeugt wird, wobei die parallelen Daten unabhängig von dem Taktsignal aus der Datenverarbeitungseinheit (32) in den Puffer (34) geschrieben werden, und die seriellen Daten aus dem Schieberegister (36) an eine nachfolgende Stufe gleichzeitig mit der Übertragung von Daten aus dem Puffer (34) an das Schieberegister (36) geliefert werden.

2. Parallel/Seriell-Datenwandlungssystem (30) nach Anspruch 1, in welchem die Erzeugungseinrichtung (EM) ein Leer-Signal-Ausgangsanschluß des Puffers (34) ist.

3. Parallel/Seriell-Datenwandlungssystem (30) nach Anspruch 1, in welchem das Schieberegister (36) mit einer konstanten Gleichspannung (600) beliefert wird.

## Revendications

1. Système de transfert de données parallèle-série (30) comprenant une unité de traitement de données (32), une mémoire tampon (34) connectée à la sortie de données parallèle de l'unité de traitement de données (32) pour garder les données parallèles écrites à partir de l'unité de traitement de données (32), un registre à décalage (36) connecté à la sortie de la mémoire tampon (34) pour convertir la sortie de données parallèle de la mémoire tampon (34) en données série, des moyens destinés à fournir des signaux d'horloge au registre à décalage (36), des moyens destinés à fournir des données série provenant du registre à décalage (36) à un étage suivant, conformément aux signaux d'horloge fournis au registre à décalage (36), et un diviseur de fréquence (40) ayant une entrée connectée aux signaux d'horloge pour fournir un signal d'horloge de sortie déduit des signaux d'horloge d'entrée divisés par un nombre prédéterminé, le signal d'horloge divisé sorti du diviseur (40) étant connecté à la mémoire tampon (34) et au registre à décalage (36) pour entraîner la lecture des données parallèles à partir de la mémoire tampon (34) et leur chargement dans le registre à décalage (36), caractérisé en ce que sont prévus des moyens (EM) destinés à générer un signal vide (500) à une sortie de la mémoire tampon (34) quand la mémoire tampon (34) ne contient aucune donnée parallèle et des moyens (42) destinés à éviter que le signal d'horloge divisé soit fourni à la mémoire tampon et au registre à décalage (36) quand le signal vide (500) est généré, les données parallèles étant écrites dans la mémoire tampon (34) sans tenir compte du signal d'horloge provenant de l'unité de traitement de données (32) et les données série étant fournies à partir du registre à décalage (36) à un étage suivant simultanément au transfert de données à partir de la mémoire tampon (34) vers le registre à décalage (36).

2. Système de transfert de données parallèle-série (30) selon la revendication 1, dans lequel les moyens de génération (EM) sont une borne vide de la mémoire tampon (34).

3. Système de transfert de données parallèle-série (30) selon la revendication 1, dans lequel le registre à décalage (36) est pourvu d'une tension continue constante (600).
